# EUROPEAN PATENT APPLICATION

(11) **EP 2 645 420 A2**
(43) Date of publication of application: **02.10.2013**
(21) Application number: 13161322.6
(22) Date of filing: 27.03.2013
(51) Int. Cl.: H01L 31/0224, H01L 31/0236, H01L 31/18

(54) **Modification and optimization of a light management layer for thin film solar cells**

(30) Priority: 30.03.2012 IN DE09812012
(71) Applicant: Moser Baer India Ltd., 110020 New Delhi (IN)
(72) Inventor: Rutten, Jos, Canandaigua, New York 14424 (US); van Erven, Rob, Canandaigua, New York 14424 (US)
(74) Representative: Beck & Rössig European Patent Attorneys

(57) **Abstract**

A method for manufacturing an optoelectronic device (100) is provided. The method includes providing a substrate (102). Thereafter, the method includes providing a lacquer layer (104) on the substrate (102). The method further includes providing light management texture in the lacquer layer (104). Providing light management texture in the lacquer layer (104) includes providing a replication substrate having a negative texture and imprinting the negative texture into the lacquer layer (104) using the replication substrate, such that the light management texture is created in the lacquer layer (104). Furthermore, the method includes providing a first electrode layer (108) on the lacquer layer (104). The method further includes etching, prior to deposition of first electrode layer (108), to enable formation of less steep light management texture in the lacquer layer (104) and subsequently less steep texture (202) on the first electrode layer (108) by etching at least one of the textures in the production of the negative texture on the replication substrate, or the light management texture on the lacquer layer (104) itself.

## Description

The invention disclosed herein relates, in general, to optoelectronic devices. More specifically, the present invention relates to a method of forming an optimized light management layer for use in the optoelectronic devices.

Efficiency of photovoltaic devices such as thin film solar cells is significantly determined by their ability to capture maximum amount of incident solar light. Currently, efficiency of the thin film solar cells is enhanced by providing a light management texture in form of random nano-texture with a texture size of around 50-200 nm on substrates of the thin film solar cells. This light management texture scatters the incident light, and hence, increases the optical path length of light, leading to more absorption of light by the semiconductor layers of the thin film solar cells.

However, the drawback of this light management texture is that the parameters of this light management texture cannot be changed easily and independently, as they are dependent on the type of materials used and the process parameters. As a result, it is not possible to independently optimize the light management texture parameters for maximum light-trapping in a given solar cell layer stack design.

Using substrates that have an optimized periodic light management texture can have a significant effect on the efficiency of the thin film solar cells because a periodic light management texture enhances trapping of light by the solar cell by also using diffraction next to scattering. A periodic light management texture can be applied on the substrates by use of lacquers and sol-gel materials.

However, the problem with current state-of-the-art methods used to create the periodic light management texture in the lacquers is that they provide a texture that is too narrow and too steep to allow conformal TCO-layer deposition.

In light of the above discussion, there is a need for an improvement in the current thin film solar cells in order to eliminate one or more drawbacks of the prior art.

The features of the present invention, which are believed to be novel, are set forth with particularity in the appended claims. The invention may best be understood by reference to the following description, taken in conjunction with the accompanying drawings. These drawings and the associated description are provided to illustrate some embodiments of the invention, and not to limit the scope of the invention.
FIG. 1 is a diagrammatic illustration of various components of an exemplary photovoltaic device according to an embodiment of the present invention;
FIGs. 2a, 2b and 2c are diagrammatic illustrations depicting texture formed on a layer of TCO according to the prior art;
FIG. 3 is a flow chart describing an exemplary method for manufacturing the photovoltaic device in accordance with an embodiment of the present invention;
FIGs. 4a, 4b, 4c, 4d and 4e depict various examples of textures formed on a lacquer layer in accordance with some embodiments of the present invention; and
FIG 5 depicts an example of a texture after the deposition of a layer of TCO in accordance with an embodiment of the present invention.

Those with ordinary skill in the art will appreciate that the elements in the figures are illustrated for simplicity and clarity and are not necessarily drawn to scale. For example, the dimensions of some of the elements in the figures may be exaggerated, relative to other elements, in order to improve the understanding of the present invention.

There may be additional structures described in the foregoing application that are not depicted on one of the described drawings. In the event such a structure is described, but not depicted in a drawing, the absence of such a drawing should not be considered as an omission of such design from the specification.

The instant exemplary embodiments provide a cost-effective method of manufacturing an optoelectronic device.

An object of the present invention is to provide a light management layer that facilitates efficient and cost-effective deposition and growth of a transparent conductive oxide (TCO) layer over the light management layer and semiconductor layers over the TCO layer.

Another object of the present invention is to provide a transparent conductive oxide layer that can be better optimized on transmission and conductivity, which improves and enhances the efficiency and quality of the optoelectronic device.

In some embodiments of the present invention, a method for manufacturing a photovoltaic device is provided. The method includes providing a substrate, followed by depositing a lacquer layer on the substrate. Thereafter, a light management texture like a light trapping texture is provided in the lacquer layer. This is followed by deposition of at least a first electrode layer like a TCO layer on the lacquer layer. The method further includes oxygen plasma etching and/or UV-O₃ treatment of the light management texture, prior to deposition of the first electrode layer. This etching step enables formation of substantially less steep light management texture on the lacquer layer and subsequently a more conformal texture of the first electrode layer. In some embodiments the process is carried out by using a plasma that includes oxygen, for example oxygen-plasma and/or a UV-O₃ treatment.

In some embodiments, a method for manufacturing an optoelectronic device is provided. The method includes providing a substrate. Thereafter, the method includes providing a lacquer layer on the substrate. The method further includes providing a light management texture in the lacquer layer. Providing the light management texture in the lacquer layer includes providing a replication substrate having a negative texture and imprinting the negative texture onto the lacquer layer using the replication substrate, such that the light management texture is created in the lacquer layer. Furthermore, the method includes providing a first electrode layer on the lacquer layer. The method further includes etching, prior to deposition of the first electrode layer, to enable formation of substantially less steep light management texture in the lacquer layer and subsequently substantially less steep texture in the first electrode layer by etching at least one of the negative texture on the replication substrate, and the light management texture provided in the lacquer layer.

Before describing the present invention in detail, it should be observed that the present invention utilizes a combination of method steps and apparatus components related to manufacturing an optoelectronic device such as a thin film solar cell. Accordingly the apparatus components and the method steps have been represented where appropriate by conventional symbols in the drawings, showing only specific details that are pertinent for an understanding of the present invention so as not to obscure the disclosure with details that will be readily apparent to those with ordinary skill in the art having the benefit of the description herein.

While the specification concludes with the claims defining the features of the invention that are regarded as novel, it is believed that the invention will be better understood from a consideration of the following description in conjunction with the drawings, in which like reference numerals are carried forward.

As required, detailed embodiments of the present invention are disclosed herein; however, it is to be understood that the disclosed embodiments are merely exemplary of the invention, which can be embodied in various forms. Therefore, specific structural and functional details disclosed herein are not to be interpreted as limiting, but merely as a basis for the claims and as a representative basis for teaching one skilled in the art to variously employ the present invention in virtually any appropriately detailed structure. Further, the terms and phrases used herein are not intended to be limiting but rather to provide an understandable description of the invention.

The terms "a" or "an", as used herein, are defined as one or more than one. The term "another", as used herein, is defined as at least a second or more. The terms "including" and/or "having" as used herein, are defined as comprising (i.e. open transition). The term "coupled" or "operatively coupled" as used herein, is defined as connected, although not necessarily directly, and not necessarily mechanically.

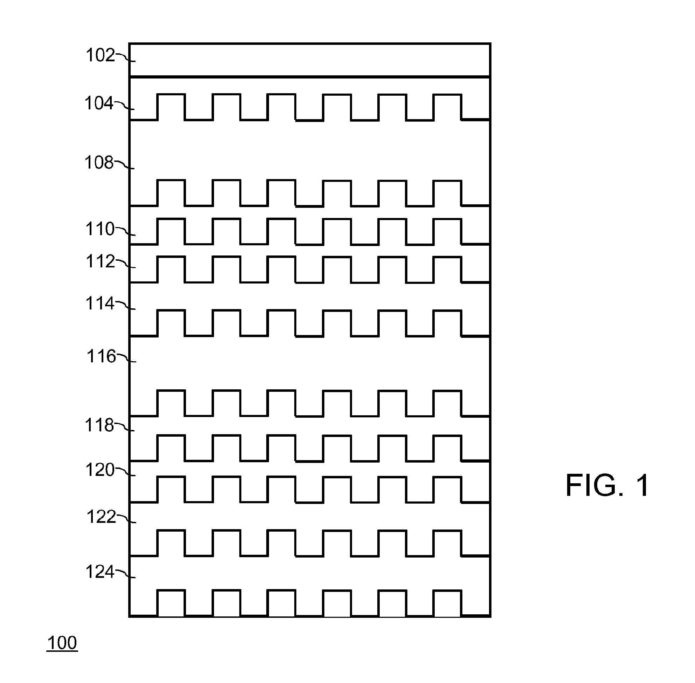

Referring now to the drawings, there is shown in FIG. 1, a diagrammatic illustration of various components of an exemplary photovoltaic device 100 according to an embodiment of the present invention. Examples of the photovoltaic device 100 include, but are not limited to, a thin film solar cell, an organic solar cell, an amorphous silicon solar cell, a microcrystalline silicon solar cell, a micromorph silicon tandem solar cell, a Copper Indium Gallium Selenide (CIGS) solar cell, a Cadmium Telluride (CdTe) solar cell, and the like. The photovoltaic device 100 is shown to include a stack of a substrate 102, a lacquer layer 104, a first layer 108 of TCO, multiple semiconductor layers 110, 112, 114, 116 and 118, a second layer 120 of TCO, a layer 122 of silver, and a layer 124 of aluminum. During the description of FIG. 1, the first layer 108 of TCO may be referred as a first electrode layer and the second layer 120 of TCO may be referred to as a second electrode layer. Further, multiple semiconductor layers 110, 112, 114, 116 and 118, the second layer 120 of TCO, the layer 122 of silver, and the layer 124 of aluminum may be collectively referred to as functional layers.

The substrate 102 provides strength to the photovoltaic device 100 and is used as a starting point for deposition of other layers that constitute the photovoltaic device 100. An example of a material of the substrate 102 includes, but is not limited to, glass and transparent plastics. In some exemplary embodiments, during real life applications, the photovoltaic device 100 is placed in a way that the substrate 102 is facing the sun and all the sun light falling on the photovoltaic device 100 is incident on the substrate 102. In these embodiments, the substrate 102 is made of a transparent material so that it allows maximum light to pass through itself and reach the subsequent layers. The substrate 102 includes a flat surface on which other subsequent layers can be deposited.

Moving on to the lacquer layer 104. The lacquer layer 104 is generally made up of a curable material and is provided over the substrate 102. The lacquer layer 104 can be provided on the substrate 102 by using a brush or roller, dispensing, screen printing, slot dye coating, spin-coating, spray coating, diverse replication techniques, or even printing. The curable material has a property to retain any light management texture embossed on it when it is cured by using mediums such as heat or light. The curable material can include, but is not limited to, a ultra-violet curable material, a photo-polymer lacquer, an acrylate, and silica- or silica-titania based sol-gel materials.

In some embodiments, the curable material is post-cured by using light and/or heat after imprinting of the texture 104 in the curable material on the substrate 102. Post-curing of the curable material is performed in order to minimize the out-gassing of fluids or solvents from the curable material during later stages of manufacturing of the photovoltaic device 100 or during actual usage of the photovoltaic device 100. These fluids or solvents coming out of the curable material have a tendency to contaminate subsequent layers of the photovoltaic device 100 and thus, impact the overall performance of the photovoltaic device 100.

In some embodiments, a barrier layer may be deposited on the lacquer layer 104 after the lacquer layer 104 has been deposited on the substrate 102. The barrier layer is impermeable to the fluids or solvents, such as volatile organic compounds like photoinitiator remains, non-reacted resins, side-reaction products or impurities, which are released by the curable material during later stages of manufacturing of the photovoltaic device 100 or during actual usage of the photovoltaic device 100. The barrier layer is also impermeable to contaminants that originate from substrates. Thus, the barrier layer prevents the detrimental effect of the contaminants/elements, fluids or solvents released by the viscous curable material and/or the substrate (like sodium from glass) 102 on other deposited layers of the photovoltaic device 100.

In accordance with the present invention, the lacquer layer 104 is deposited in a manner such that a light management texture can be provided in a surface of the lacquer layer 104. The examples of the light management texture include, but are not limited to, 1D or 2D periodic U-shaped features, a 1D or 2D periodic sinusoidal grating, 1D or 2D periodic upright or inverted pyramids, random upright or inverted pyramids, 1D or 2D periodic inverted cones, and other micro and nano-sized structures. This light management texture is such that it enables and enhances the light trapping capability of semiconductor layers of the photovoltaic device 100. This light management texture helps in scattering and diffraction of the light and thus, enhances the light path through the photovoltaic device 100 and hence, enhances the chance of absorption of light by the semiconductor layers of the photovoltaic device 100. Therefore, the light management texture can also be called light trapping texture and as this light management texture is formed in the lacquer layer 104, therefore, the lacquer layer 104 can be called light trapping layer.

Several methods can be used to create the light management texture in the lacquer layer 104 that enables light trapping. In one embodiment, the light management texture can be created by applying a thin layer of the lacquer (curable material) 104, such as a photo-polymer lacquer or a sol-gel material, onto the substrate 102 and then pressing a replication substrate like a stamper having negative texture into this lacquer layer 104. This negative texture which is actually an inverse impression of the light management texture in the lacquer layer 104 enables imprinting of a positive texture (mirror image of the negative texture) in the lacquer layer 104. This positive texture imprinted in the lacquer layer is the light management texture. Further, a UV curing process is applied to freeze the light management texture in the layer of the curable material 104.

In another embodiment, the light management texture can be created by applying a thin layer of the thermally curable lacquer 104, such as a photo-polymer lacquer or a sol-gel material, onto the substrate 102 and then pressing the stamper having the negative texture into this lacquer layer 104. Further, heat is applied to the lacquer layer 104 in order to freeze the light management texture on the lacquer layer 104.

In yet another embodiment, the light management texture can be created by pressing the stamper against the substrate 102 while it is being heated above its deformation (glass transition) temperature (hot-embossing), followed by a rapid cooling process. In another embodiment, the light management texture can be created by use of injection molding technique. In this embodiment, an injection molding die is mounted on the surface of the substrate 102 and the light management texture is formed by injecting the lacquer in the injection molding die.

In some embodiments, after the lacquer layer 104 has been deposited over the substrate 102, annealing of the lacquer layer 104 is performed.

Once the lacquer layer 104 has been deposited over the substrate 102, the first layer 108 of TCO is provided over the lacquer layer 104. TCOs are doped metal oxides used in photovoltaic devices. Examples of TCOs include, but are not limited to, Zinc Oxide, Tin Oxide, Aluminum-doped Zinc Oxide (AZO), Boron doped Zinc Oxide (BZO), Gallium doped Zinc Oxide (GZO), Fluorine doped Tin Oxide (FTO), Indium Zinc Oxide and Indium doped Tin Oxide (ITO). TCOs have more than 80% transmittance of incident light and have conductivities higher than 10³ S/cm for efficient carrier transport. The transmittance of TCOs, just as in any transparent material, is limited by light scattering at defects and grain boundaries.

Generally, the TCO is deposited by Physical Vapor Deposition (PVD). Deposition of TCO by PVD, generally, provides the first layer 108 of TCO having a relatively flat surface. In other embodiments of the invention, the first layer 108 of TCO can be deposited on the lacquer layer 104 by using Low Pressure Chemical Vapor Deposition (LPCVD), Atmospheric Pressure Chemical Vapor Deposition (APCVD), or even Plasma Enhanced Chemical Vapor Deposition (PECVD) and the like. Further, this first layer 108 of TCO usually has a relatively flat surface that needs a post treatment like wet etching to create a light management texture. Often, this random texture created by wet chemical etching does not yield optimal light trapping for thin-film solar cells and is difficult to control. Furthermore, this process requires thicker TCO layers to be deposited first and then these thicker TCO layers are subsequently etched back up to 30-50%. Because TCO deposition is a slow and expensive process, etching of thicker TCO layers to optical light management texture impacts the throughput and costs negatively.

Additionally, the problem with methods described above to create the light management texture on the TCO 108 is that all these methods are carried out either by growing thick layers of TCO 108 that have their own native roughness or by etching the thicker layers with Hydrochloric Acid (HCL) or HCL/HF to form the light management texture.

Further, because of the above stated limitations, the first layer 108 of TCO needs to be optimized for transmission, conductivity and morphology after growth or after etching. This optimization also results in a random texture on the first layer 108 of TCO.

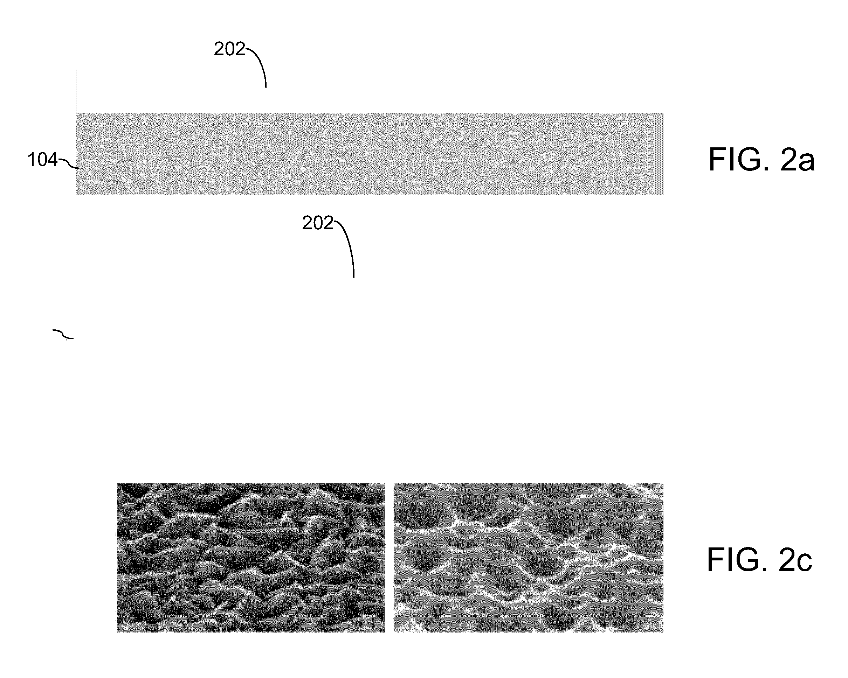

In the prior art, some examples of the texture formed on the first layer 108 of TCO have been depicted in FIGs. 2a, 2b, and 2c. These textures 202 are formed during deposition of the first layer 108 of TCO. Although, these textures 202 improve the efficiency of the photovoltaic device 100 by increasing optical path of light by scattering, the problem with these random textures 202 is that these random textures 202 do not yield optimal light trapping for the photovoltaic device 100 and are difficult to control regarding uniformity. Apart from this, these random textures 202 also have tendency to create defects due to the sharp features on subsequent semiconductor layers 110, 112, 114, 116 and 118.

Moving on to the next set of layers. Next set of layers in the stack of photovoltaic device 100 are semiconductor layers 110, 112, 114, 116, and 118. Generally, the semiconductor layers are deposited using Plasma Enhanced Chemical Vapor Deposition (PECVD), sputtering, Close Space Sublimation (CSS), Chemical Vapor Deposition, hot wire techniques, and the like on the first layer 108 of TCO. For the purpose of this description, the semiconductor layers are shown to include a first layer of p-doped semiconductor 110, a second layer of p-doped semiconductor 112, a layer of buffer 114, a layer of intrinsic semiconductor 116, and a layer of n-doped semiconductor 118. However, it will be readily apparent to those skilled in the art that the photovoltaic device 100 can include or exclude one or more semiconductor layers without deviating from the scope of the invention.

For the purpose of this description, the first layer of p-doped semiconductor 110 is made of µc-Si:H. However, the second layer of p-doped semiconductor 112, the layer of intrinsic semiconductor 116, and the layer of n-doped semiconductor 118 are made of a-Si:H.

In general, when glass is used as a superstrate, the semiconductor layers are deposited in a p-i-n sequence, i.e. p-doped semiconductor, intrinsic semiconductor, and n-doped semiconductor. This is because the mobility of electrons in a-Si:H is nearly twice that of holes in a-Si:H, and thus the collection rate of electrons moving from the p- to n-type contact is better as compared to holes moving from p- to n-type contact. Therefore, the p-doped semiconductor layer is placed at the top where the intensity of light is higher.

Following the semiconductor layers, a back contact is deposited. In one embodiment, the back contact includes the second layer 120 of TCO, the layer 122 of silver, and the layer 124 of aluminum. In other embodiments, the cover substrate can include at least one of the second layer 120 of TCO, the layer 122 of silver, and the layer 124 of the aluminum. These layers individually or in combination form the back contact of the photovoltaic device 100. In some cases, commercially available photovoltaic devices 100 may have additional layers to enhance their efficiency or to improve the reliability.

All the above mentioned layers are encapsulated using an encapsulation material to obtain the photovoltaic device 100.

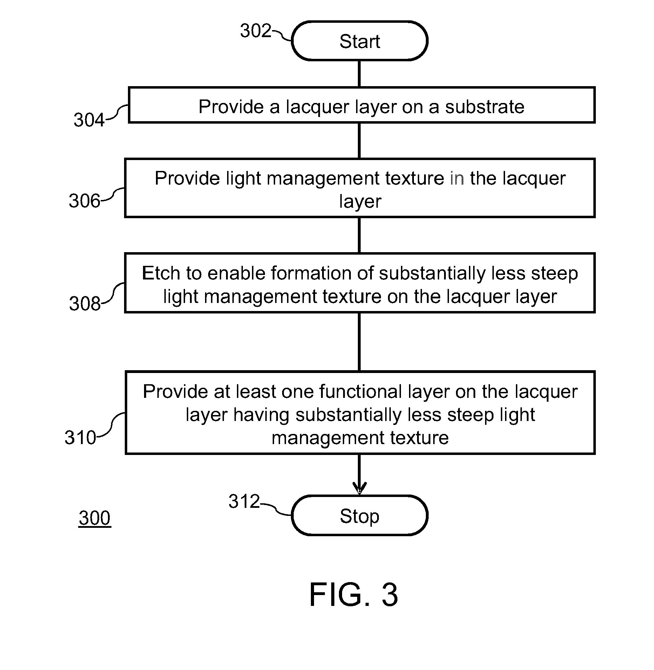

Moving on to FIG. 3, FIG. 3 is a flow chart describing an exemplary method 300 for manufacturing the photovoltaic device 100 in accordance with an embodiment of the present invention. To describe the method 300, reference will be made to FIG. 1, although it is understood that the method 300 can be implemented to manufacture any other suitable device such as an organic light emitting device (OLED), an optoelectronic device, and the like. Moreover, the invention is not limited to the order of in which the steps are listed in the method 300. In addition, the method 300 can contain greater or fewer numbers of steps than those shown in FIG. 3.

Also, for the purpose of description, the method 300 has been explained in reference to a photovoltaic device and light trapping, however, it will be readily apparent to those ordinarily skilled in the art that the present invention can be implemented in any other optoelectronic device like an OLED as well, for light management purposes like light extraction.

The method 300 for manufacturing the photovoltaic device 100 is initiated at step 302. As described in conjunction with FIG. 1, the substrate 102 is used as a starting point for deposition of the photovoltaic device 100 and provides strength to the photovoltaic device 100. The substrate 102 is transparent in nature and can be made of materials such as glass and transparent plastic. The substrate 102 is made of a transparent material so that it can allow maximum light to pass through itself and reach the subsequent semiconductor layers. Further, the substrate 102 includes a substantially flat surface on which other layers of the photovoltaic device 100 can be deposited.

At step 304, the lacquer layer 104 is provided on the substrate 102. In one embodiment, the lacquer layer 104 can be of viscous curable material such as, but is not limited to, an ultra-violet curable material, a photo-polymer lacquer, an acrylate, and a sol-gel material. Further, the method 300 includes providing the light management texture in the lacquer layer 104 at step 306. This light management texture is such that it that enables and enhances the light trapping capability of the semiconductor layers of the photovoltaic device 100. This light management texture helps in scattering and diffraction of the light and thus, enhances the light path through the photovoltaic device 100 and hence, enhances the chance of absorption of light by the semiconductor layers of the photovoltaic device 100. Therefore, the light management texture can also be called light trapping texture and as this texture is formed in the lacquer layer 104, therefore, the layer 104 can be called light trapping layer or light management texture. In an embodiment, the lacquer layer 104 can also undergo a process of degassing after being cured. The step of degassing is carried out in an enriched nitrogen atmosphere as a protection against oxidation of the lacquer layer 104. This step is necessary because, even though the lacquer has been UV-cured, organic compound molecules evaporate during exposure to elevated temperatures which are used, for instance during the sputtering of the TCO layer 108.

In one embodiment, the light management texture is provided by using a replication substrate having a negative texture, such as a stamper. In this embodiment, the light management texture is created in the lacquer layer 104 by imprinting said negative texture into the lacquer layer 104 by using the replication substrate such as the stamper. Various types of stampers can be used for creating the light management texture on the lacquer layer 104. A few examples of stampers may include a rigid stamper and a flexible stamper having different shapes, sizes and forms depending upon the type of light management texture desired. For example, the light management textures can be of various shapes such as V-shaped or U-shaped features, a 1D or 2D periodic grating (rectangular or sinusoidal), a blazed grating, and random pyramids. Generally, such stampers are fabricated by, for example, laser interference lithography or replica's from existing random textures like pyramid etched monocrystalline silicon or thick TCO layers with native texture. In an embodiment, the stamper may be a nickel based rigid master stamper which can be replicated to form flexible polycarbonate based stampers.

Generally, the light management texture obtained by step 306 does not yield optimal light trapping for the photovoltaic device 100, because it is difficult to grow conformal device structures on such non-treated textures.

In order to optimize the light management texture regarding more conformal growth, at step 308, etching (by e.g. O₂-plasma and/or UV-O₃ treatment) is performed to enable formation of substantially less steep light management texture on the lacquer layer 104. The light management texture on the lacquer layer 104 is more open in nature, for example, a less steep light management texture will have gently sloping side walls, allowing easier deposition of subsequent layers and propagating similar texture through subsequent layers deposited.

In an embodiment, the light management texture is treated with oxygen plasma. The substrates that need to be treated are loaded in a "barrel" that is evacuated by a dry vacuum pump. Thereafter, when a pre-defined pressure point is reached, a flow of pure oxygen is introduced into the barrel and a plasma is ignited. This starts a chemical reaction, during which the reaction the lacquer molecules on the surface are oxidized and evacuated as CO2, leading to formation optimized light management texture.

In another embodiment, treatment with a combination of UV-light and ozone (03) is carried out on the light management texture. According to an embodiment, a mercury lamp is used to produce a light that includes two wavelengths. First being a spectral line (184.9 nm) that is responsible for creation of ozone and second wavelength (253.7 nm) for destroying the ozone molecules. This results in creation of highly reactive atomic oxygen. The oxygen atoms oxidize the lacquer surface leading to the formation of an optimized light management texture.

In yet another embodiment, the UV-light and ozone (03) can be consecutively followed or preceded by the oxygen plasma treatment to achieve optimized light management texture. Further, usually the step 308 of etching is performed for a time period ranging from 5 to 30 minutes, at a temperature ranging from 25 to 100 deg C.

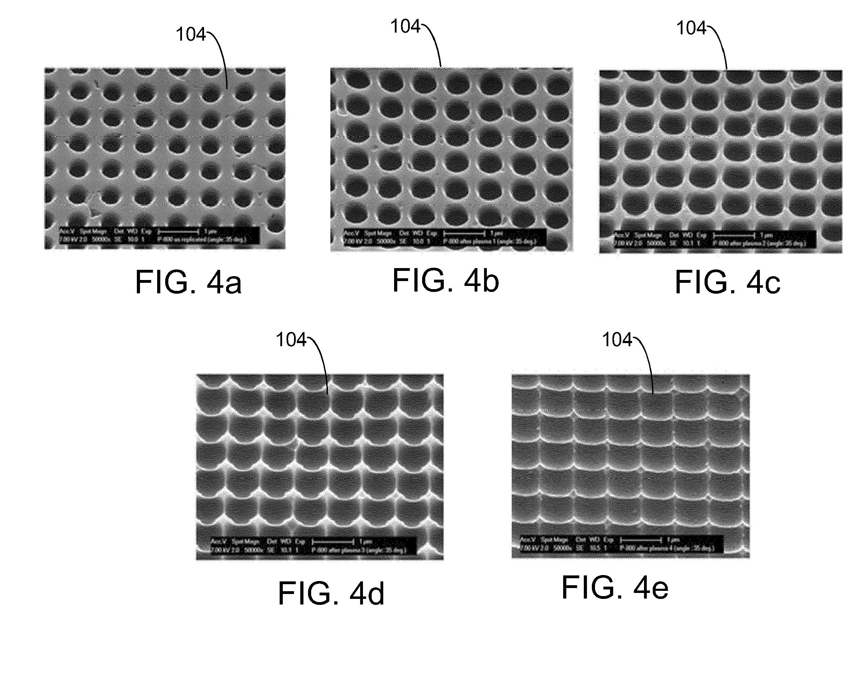

To elaborate more, the light management texture obtained by step 306, for example, can be a 2D grating texture that is made by, for example, Laser Interference Lithography (LIL). However, such a light management texture requires an extra modification to yield optimal light trapping for the photovoltaic device 100. Generally, with LIL a 2D grating texture that consists of pyramids or holes can be made, but for a good texture in combination with TCO deposition a much more open texture is required. Since, this open texture cannot be made in a single step; therefore, etching may be performed on the light management texture provided on the lacquer layer 104 to enhance the light trapping ability. In some cases, for example, etching may be done using an oxygen plasma etching process (O₂-plasma treatment). According to the process, plasma is generated from a gas including oxygen and using the generated plasma to perform the etching. The plasma being used causes chemical reactions between the material being etched and elements in the plasma resulting in formation of features of required shape and size on the material being etched. Some of the examples of textures formed on the lacquer layer 104 by the oxygen plasma etching process for different time duration of etching have been depicted in FIGs. 4a, 4b, 4c, 4d and 4e.

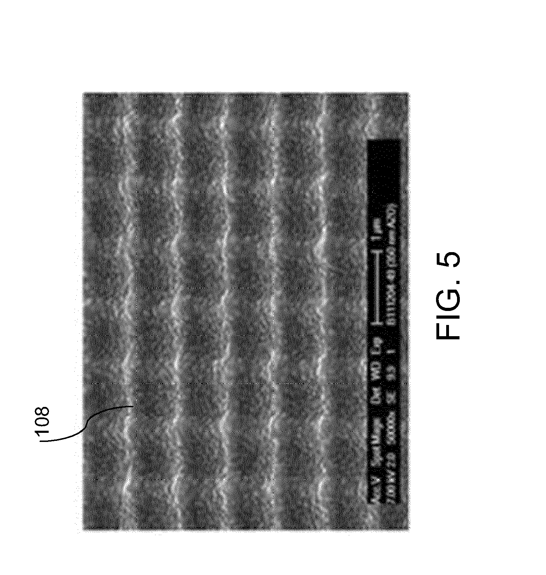

In this embodiment, post-treatment of the light management texture formed in the lacquer layer 104 using the oxygen plasma etching process reduces the steepness of the light management texture, thus creating a more open texture. This also enables the formation of the desired optimal texture on the first electrode layer, i.e. the first layer of TCO 108 that is deposited at step 310. The texture is created on the first layer of TCO 108 because of the light management texture formed in the lacquer layer 104 has a shape substantially similar to the shape of the light management texture on the lacquer layer 104. However, as depicted in FIG 5, the first layer of TCO 108 deposited at step 310 usually has substantially less steep texture. Also, in an embodiment, the texture of the TCO layer 108 is substantially similar and conformal to shape and size of the light management texture formed in the lacquer layer 106. Because of this, the need of post treatment of the first layer of TCO 108 is eliminated and this method 300 also allows a thinner layer of TCO 108 to be deposited having height ranging between 250 nanometers and 500 nanometers. For example, for method 300, thickness of TCO layer can be 300 nanometers as compared to a generally used thickness of greater than 600 nanometers of TCO layers conventionally. However, it is to be understood that, even though the thickness of TCO layer is preferably within the range of 250 to 500 nm, in some embodiments this thickness can be lower or greater than this range, without deviating from the scope of the invention.

In another embodiment, the replication substrate having the negative texture, for example the stamper, is created from the post treated replica having the inverse texture of an oxygen plasma treated replica. Further, this replication substrate is used to imprint the desired light management texture directly during the replication. By using this replication substrate for providing the light management texture in the lacquer layer 104, the light management texture, thus formed, has the desired openness, steepness or wall angle which enables the formation of the optimal texture on the first layer of TCO 108 during TCO deposition. For example, in an embodiment, height of the light management texture ranges from 100 to 500 nm and periodicity between adjacent textures ranges from 600 to 1200 nm. However, it is to be understood that, even though the height of the light management texture is preferably within the range of 100 to 500 nm, in some embodiments this height can be lower or greater than this range, without deviating from the scope of the invention.

Following deposition of the first layer 108 of TCO on the lacquer layer 104, multiple semiconductor layers are deposited on the first layer 108 of TCO. These multiple semiconductor layers can include the first layer of p-doped semiconductor 110, the second layer of p-doped semiconductor 112, the layer of buffer 114, the layer of intrinsic semiconductor 116, and the layer of n-doped semiconductor 118. As described in conjunction with FIG. 1, the semiconductor layers are deposited in a manner that they form a p-i-n structure.

Following this, the back contact is provided on the multiple semiconductor layers. The back contact can include the second layer 120 of TCO (second electrode layer), the layer 122 of silver, and the layer 124 of aluminum. Further, all the layer constituting the photovoltaic device 100 are encapsulated between the back contact and substrate 102. The method 300 is terminated at step 312.

Various embodiments, as described above, provide a light trapping layer for use in a thin film solar cell, which has several advantages. One of the several advantages of some embodiments of this method is that light trapping capability of the photovoltaic device 100 is increased because of using diffraction next to scattering. Further, this also results in a significant higher throughput and reduced costs, due to thinner layer of TCO and semiconductor deposition. Another advantage of this invention is that it improves and enhances the efficiency and quality of the thin film solar cells.

While the invention has been disclosed in connection with the preferred embodiments shown and described in detail, various modifications and improvements thereon will become readily apparent to those skilled in the art. Accordingly, the spirit and scope of the present invention is not to be limited by the foregoing examples, but is to be understood in the broadest sense allowable by law.

All documents referenced herein are hereby incorporated by reference.

## Claims

1. A method for manufacturing an optoelectronic device (100), said method comprising the steps of:
providing a substrate (102);
providing a lacquer layer (104) on said substrate;
providing light management texture in said lacquer layer (104), comprising:
providing a replication substrate having a negative texture; and
imprinting said negative texture into said lacquer layer using said replication substrate, such that said light management texture is created in said lacquer layer;
providing at least a first electrode layer (108) on said lacquer layer (104);
etching to enable formation of said light management texture (202) in said lacquer layer (104);
**characterized in that**
said etching enables formation of substantially less steep said light management texture in said lacquer layer (104) and subsequently substantially less steep said texture (202) on said first electrode layer (108), said etching being performed on at least one of :
said negative texture on said replication substrate, and
said light management texture provided in said lacquer layer (104),
wherein said etching is performed prior to providing said first electrode layer (108).

2. The method according to claim 1, wherein said replication substrate is a master stamper, said master stamper being replicated to form a plurality of replication substrates for imprinting said negative texture into said lacquer layer (104).

3. The method according to claim 1 or 2, wherein said first electrode layer (108) is a TCO layer (108), further wherein a height of said TCO layer (108) on said lacquer layer (104) ranges from 250 nm to 500 nm.

4. The method according to one of claims 1 to 3, further comprising:
a. depositing one or more semiconductor layers (110, 112, 114, 116, 118) on said first electrode layer (108);
b. depositing a second electrode layer (120) on said one or more semiconductor layers (110, 112, 114, 116, 118); and
c. encapsulating said lacquer layer (104), said first electrode layer (108), said one or more semiconductor layers (110, 112, 114, 116, 118), and said second electrode layer (120) between a cover substrate (122, 124) and said substrate (102) of said optoelectronic device (100).

5. The method according to one of claims 1 to 4, wherein said etching of said light management texture comprises:
a. generating a plasma from a processing gas comprising oxygen; and
b. etching said light management texture using said plasma.

6. The method according to one of claims 1 to 5, wherein said etching is performed for a time period ranging from 5 to 30 minutes.

7. The method according to one of claims 1 to 6, wherein said etching is performed at a temperature ranging from 25 to 100 °C.

8. The method according to one of claims 1 to 7, wherein a material of said first electrode layer (108) is selected from one or more of zinc oxide, aluminum zinc oxide, boron zinc oxide, gallium zinc oxide, tin oxide, indium-tin-oxide, and indium zinc oxide.

9. The method according to one of claims 1 to 8, wherein said light management texture formed in said lacquer layer (104) enables light trapping when said optoelectronic device (100) is a photovoltaic device and said light management texture formed in said lacquer layer (104) enables light extraction when said optoelectronic device (100) is a light emitting device.

10. The method according to one of claims 1 to 9, wherein said first electrode layer (108) is a Transparent Conductive Oxide layer (108), whereby a texture is created on said Transparent Conductive Oxide layer (108) because of said light management texture formed in said lacquer layer (104), wherein said texture (202) having a shape substantially similar to a shape of said light management texture.
